# EUROPÄISCHE PATENTANMELDUNG

(11) **EP 2 048 745 A2**
(43) Veröffentlichungstag der Anmeldung: **15.04.2009**
(21) Anmeldenummer: 08166056.5
(22) Anmeldetag: 08.10.2008
(51) Int. Cl.: H01R 12/34

(54) **Anordnung aus Steckelement und Leiterplatte**

(30) Priorität: 09.10.2007 DE 102007050355
(71) Anmelder: Würth Elektronik ICS GmbH & Co. KG, 74613 Öhringen (DE)
(72) Erfinder: Wittig, Klaus, 74613, Öhringen (DE); Kallee, Werner, 74177, Bad Friedrichshall (DE)
(74) Vertreter: Patentanwälte Ruff, Wilhelm, Beier, Dauster & Partner

(57) **Zusammenfassung**

Die Erfindung schlägt vor, Steckelemente wie Schaltelemente, beispielsweise Relais oder Sicherungen, anstelle von Flachsteckzungen mit Kontaktstiften (3) zu versehen, die dort angeordnet sind, wo die Seitenkanten der bisherigen Flachsteckzungen angeordnet sind. Für jede Flachsteckzunge wird also ein Paar von Kontaktstiften verwendet, gegebenenfalls auch ein dritter Kontaktstift in der Mitte. Diese Kontaktstifte lassen sich in durchkontaktierte Bohrungen (5) einer Leiterplatte (4) einpressen, so dass zur Anbringung eines solchen Schaltelements oder Steckelements kein Sockel mehr erforderlich ist.
Auch eine direkte Verbindung der Schaltelemente in SMT Technik wird vorgeschlagen.

## Beschreibung

Die Erfindung betrifft eine Anordnung aus einem Steckelement beziehungsweise Schaltelement und einer Leiterplatte zur Kontaktierung des Steckelements, insbesondere zur Verwendung in einem Kraftfahrzeug.

In Kraftfahrzeugen werden elektrische Verbraucher, die einen höheren Stromverbrauch haben, in der Regel über Relais geschaltet, also Schaltelemente. Diese Schaltelemente haben eine typisierte Anordnung von Kontakten. Die zur Verbindung mit dem Stromnetz dienenden Kontakte dieser Schaltelemente sind üblicherweise als Flachsteckzungen ausgebildet und werden in Sockel eingesteckt. Diese Sockel sind bei älteren Kraftfahrzeugen noch einzeln an den entsprechenden Stellen des Kraftfahrzeugs angeordnet. Sowohl die Größe der Flachsteckzungen als auch ihre räumliche Anordnung sind dabei typisiert.

Die Flachsteckzungen haben einen lang gestreckten rechteckigen Querschnitt. Die Sockel greifen an diesen Flachsteckzungen an, so dass sich geringe Übergangswiderstände ergeben.

Soll ein solches Schaltelement auf einer Leiterplatte angebracht werden, was direkt nicht möglich ist, so werden Sockel verwendet, die beispielsweise in Einpresstechnik mit der Leiterplatte verbunden werden. Dann kann in einen solchen Sockel ein herkömmliches Schaltelement eingesteckt werden. Die Sockel haben natürlich den Nachteil, dass sie die Bauhöhe der Einheit aus Leiterplatte und Schaltelement vergrößern.

Etwas Ähnliches gilt für Stecker, die an den Enden von Leitungen angebracht sind und mit der Leiterplatte verbunden werden sollen. Auch hierfür gibt es Stecksockel, die in Einpresstechnik mit der Leiterplatte verbunden sind. Auch solche Stecker haben Flachsteckzungen.

Der Erfindung liegt die Aufgabe zu Grunde, die Möglichkeit zu schaffen, Steckelemente, beispielsweise Schaltelemente, in einfacher Weise mit Leiterplatten zu verbinden, damit Vorteile von Leiterplattenmontagen auch in der Kfz- Elektronik Einzug halten können.

Zur Lösung dieser Aufgabe schlägt die Erfindung ein Steckelement mit den im Anspruch 1 genannten Merkmalen vor. Weiterbildungen der Erfindung sind Gegenstand der Unteransprüche.

Das von der Erfindung vorgeschlagene Steckelement weist also Kontaktelemente auf, die sich auf eine der möglichen Arten direkt mechanisch und leitend mit der Leiterplatte verbinden lassen, beispielsweise als Kontaktstifte, die auf herkömmliche Art mit der Leiterplatte verlötet werden können.

In Weiterbildung der Erfindung kann vorgesehen sein, dass die Kontaktelemente als zum Einpressen geeignete Kontaktstifte ausgebildet sind, die sich in durchkontaktierte Bohrungen einer Leiterplatte einpressen lassen und auf diese Weise sowohl einen leitenden Kontakt als auch eine mechanisch sichere Verbindung mit der Leiterplatte herstellen.

In Weiterbildung der Erfindung kann vorgesehen sein, dass die räumliche Anordnung der Kontaktstifte der räumlichen Anordnung der genormten Flachsteckzungen entspricht. Damit kann erreicht werden, dass Handhabungsautomaten oder sonstige Einrichtungen, mit denen die Schaltelemente eingesetzt werden, nicht geändert zu werden brauchen. Die Steckung als Einpressvorgang in die Leiterplatten kann in der gleichen geometrischen Anordnung erfolgen wie das bisherige Einstecken in Sockel.

Für die höher belasteten Kontakte kann erfindungsgemäß vorgesehen sein, dass anstelle einer Flachsteckzunge, wobei dies auch wörtlich zu verstehen ist, zwei Kontaktstifte angeordnet werden, die beispielsweise Teil eines metallischen aus Blech geprägten Elements sind. Sie sind also beispielsweise innerhalb des Gehäuses direkt miteinander verbunden. Es kann dabei vorgesehen sein, dass diese beiden Kontaktstifte dort angeordnet werden, wo bei den bisherigen Flachsteckzungen die Seitenkanten waren.

Bei noch stärker strombelasteten Kontakten kann erfindungsgemäß vorgesehen sein, dass eine Flachsteckzunge durch drei Kontaktstifte ersetzt wird, die längs einer Linie nebeneinander angeordnet sind.

Erfindungsgemäß können Kontaktstifte verwendet werden, die als massiver im Querschnitt rechteckiger oder besser noch quadratischer Stift ausgebildet sind. Es ist aber auch möglich und wird von der Erfindung vorgeschlagen, dass ein Kontaktstift auch einen Längsschlitz aufweisen kann, der entweder an beiden Enden geschlossen oder an einem Ende offen ist. Dadurch kann eine gewisse Nachgiebigkeit der Kontaktstifte in einer Richtung quer zur Einpressrichtung erreicht werden. Hier ist es auch denkbar, dass ein derartiges ausgestaltetes Schaltelement wieder abgenommen werden kann.

Als Beispiel für ein Schaltelement wird ein Relais genannt, bei dem also mithilfe einer Steuerspannung ein Leistungsschalter geöffnet oder geschlossen wird.

Ein zweites Beispiel für ein derartiges Schaltelement ist eine Schmelzsicherung, die bei Überschreiten einer bestimmten durch eine Strombelastung erzeugten Temperatur den Stromkreis dauerhaft öffnet.

Die Erfindung schlägt ebenfalls eine Leiterplatte für ein derartiges Steckelement vor, die durchkontaktierte Bohrungen in einem Muster aufweist, das der Anordnung der typisierten Steckelemente, insbesondere Schaltelemente mit Flachsteckzungen entspricht.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: die Seitenansicht eines Schaltelements nach der Erfindung;
- Figur 2: die Draufsicht auf einen Teil einer Leiterplatte mit durchkontaktierten Bohrungen zur Anbringung des Schaltelements der Figur 1;
- Figur 3: die Seitenansicht eines Mikrorelais;
- Figur 4: die Draufsicht auf einen Teil einer Leiterplatte zur Anbringung des Mikrorelais der Figur 3;
- Figur 5: die Seitenansicht einer Schmelzsicherung;

- Figur 6: in vergrößertem Maßstab zwei an einem gestanzten Blechteil angeordnete Kontaktstifte;
- Figur 7: in nochmals vergrößertem Maßstab zwei geschlitzte Kontaktstifte zum Ersatz einer Flachsteckzunge;
- Figur 8: eine Seitenansicht eines Kontaktelements für SMT;
- Figur 9: eine der Figur 7 entsprechende Darstellung einer weiteren Ausführungsform;
- Figur 10: einen Kontaktstift einer nochmals weiteren Ausführungsform;
- Figur 11: eine Seitenansicht eines Steckers als mit der Leiterplatte zu verbindendes Steckelement.

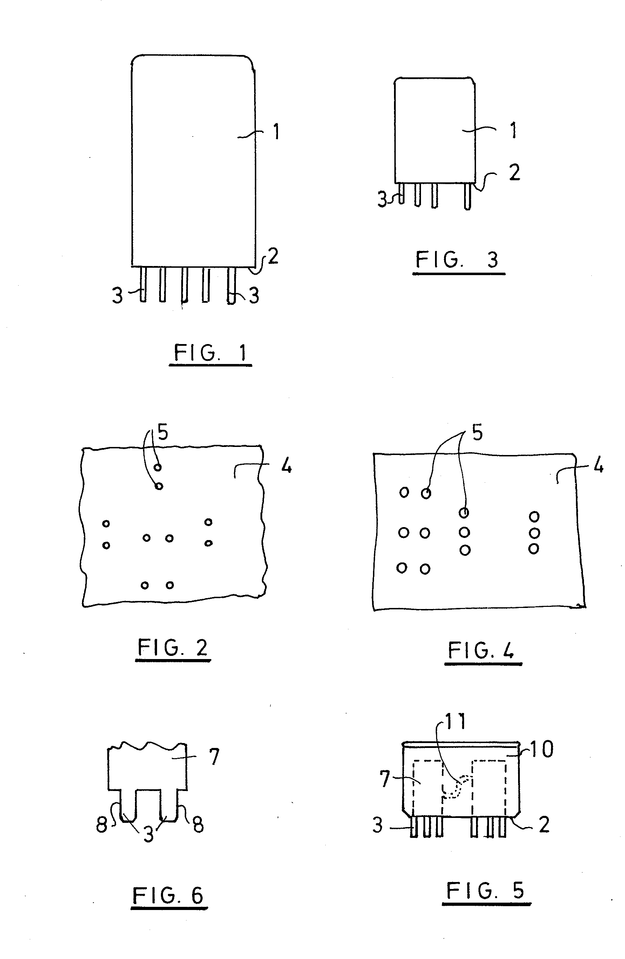

Figur 1 zeigt die Seitenansicht eines Relais, das in seinem inneren Aufbau und seiner Wirkungsweise einem bekannten Relais entspricht. An Stelle der üblichen Flachsteckzungen weist dieses Gehäuse 1 an seiner in Figur 1 unten zu sehenden Unterseite 2 mehrere Kontaktstifte 3 auf. Diese Kontaktstifte 3 sind in einer Weise angeordnet, die der Anordnung von Flachsteckzungen bei den bisherigen Schaltelementen entspricht.

Die Kontaktstifte 3 sind als im Querschnitt quadratische metallische Stifte ausgebildet. Zu ihrer Kontaktierung dienen in der Leiterplatte 4 angeordnete durchkontaktierte Bohrungen 5, die an der gleichen Stelle angeordnet sind, wo bei den bisher bekannten Schaltelementen die Flachsteckzungen angeordnet wären. Dabei entspricht das in Figur 2 zu sehende Bohrbild einem herkömmlichen Standardrelais, während das in Figur 4 zu sehende Bohrbild mit den durchkontaktierten Bohrungen einem Mikrorelais entspricht, das in Seitenansicht in Figur 3 dargestellt ist.

Bei dem in Figur 3 dargestellten Mikrorelais sind zum Ersatz zweier Flachsteckzungen in der Leiterplatte 4 zwei nebeneinander angeordnete durchkontaktierte Bohrungen 5 vorgesehen, siehe rechts in Figur 4. Dies entspricht den höher strombelasteten Kontaktelementen des Mikrorelais.

Figur 6 zeigt in vergrößertem Maßstab, wie an einem ausgestanzten Stück Blech 7 zwei Kontaktstifte 3 ausgebildet sind, deren Außenkanten 8 den gleichen Abstand voneinander aufweisen wie die Außenkanten einer bisherigen Flachsteckzunge.

Figur 5 zeigt anstelle eines Relais eine Schmelzsicherung, die ebenfalls ein beispielsweise durchscheinendes Gehäuse 10 aufweist, in dem zwei Metallbleche 7 untergebracht sind. Diese gehen außerhalb der Unterseite 2 des Gehäuses 10 in jeweils drei Kontaktstifte 3 über. Zwischen den beiden metallischen Elementen 7 ist innerhalb des Gehäuses 10 ein Metallelement 11 angeordnet, das die eigentliche Schmelzsicherung bildet.

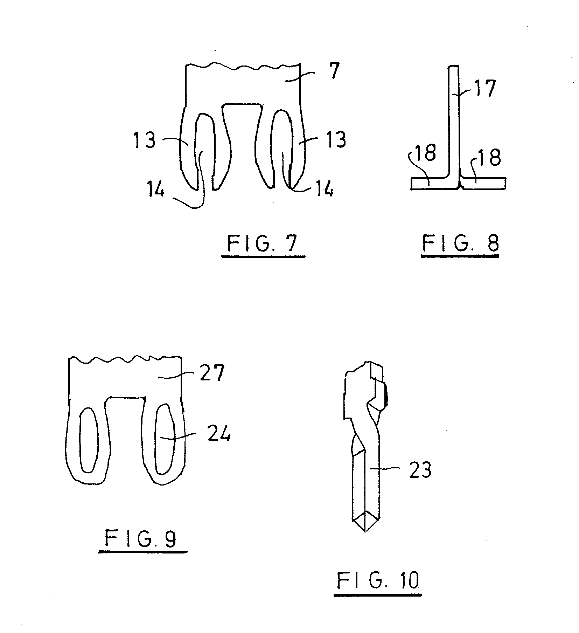

Während bei den bisher dargestellten Ausführungsformen die Kontaktstifte 3 als massive aus Metall bestehende Stifte ausgebildet sind, zeigt die Figur 7 eine Ausführungsform, bei der jeder Kontaktstift 13 einen von seinem freien Ende ausgehenden Längsschlitz 14 aufweist. Die Außenseiten der Kontaktstifte 13 verlaufen geschwungen, um das Einsetzen in die durchkontaktierten Bohrungen 5 zu erleichtern. Eine derartige Form der Kontaktstifte ist aus dem deutschen Gebrauchsmuster 20218295 bekannt, dessen Beschreibung durch Bezugnahme zum Inhalt der vorliegenden Beschreibung gemacht wird, so dass dies nicht näher erläutert wird.

Mithilfe der von der Erfindung vorgeschlagenen Anordnung von Kontaktstiften anstelle von Flachsteckzungen wird es möglich, ohne Änderungen von sonstigen beispielsweise auch inneren Aufbauten von Schaltelementen die in der Leiterplattentechnik bekannten Kontaktierungsverfahren mithilfe von durchkontaktierten Bohrungen auch in der Kraftfahrzeugelektronik zu verwenden. Die Kontaktstifte, die eine Flachsteckzunge ersetzen sollen, können in ihrem nicht zur Kontaktierung mit der Leiterplatte bestimmten Bereich 7, der innerhalb des Gehäuses angeordnet wird, genau den gleichen Aufbau aufweisen wie die bisherigen Flachsteckzungen. Dies betrifft nicht nur den Ort der Anordnung, sondern auch die Abmessungen in alle Richtungen.

Figur 8 zeigt ein Kontaktelement 17 aus einer Richtung quer zur Richtung der Figur 6 und 7 . Dieses Kontaktelement ist in seinem Endbereich mit einem nach links und einem nach rechts abgebogenen Ende 18 versehen, die beide mit ihren Unterseiten in der gleichen Ebene liegen. Die Enden könnten auch nach einer Seite abgebogen sein. Ein solches Kontaktelement 17, das aus einem Schaltelement 1 herausragt, kann dazu dienen, das Schaltelement in SMT Technologie auf den Lötpads einer Leiterplatte anzulöten.

Figur 9 zeigt eine der Figur 7 entsprechende Darstellung, bei der das Kontaktelement 27 zwei Kontaktstifte aufweist, die ähnlich aufgebaut sind wie die Kontaktstifte 13 der Ausführungsform nach Figur 7. Der Längsschlitz 24 bei dieser Ausführungsform ist jedoch an beiden Enden geschlossen. Die Außenseiten der Kontaktstifte verlaufen geschwungen, um das Einsetzen zu erleichtern.

Während bei den Ausführungsformen der Figur 6 von im Querschnitt rechteckigen Kontaktstiften ausgegangen wird, die sich aus dem Kontaktelement 7 ergeben, zeigt Figur 10 einen Kontaktstift 23, der im Querschnitt ebenfalls rechteckig ist, der aber gegenüber dem eigentlichen Kontaktelement tordiert ist.

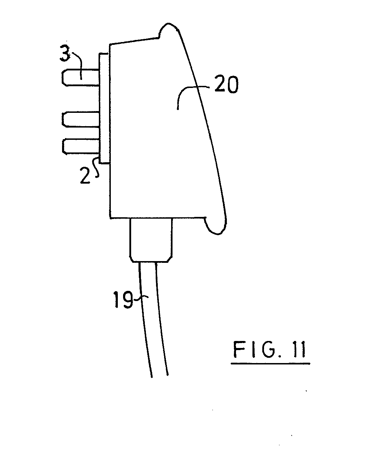

Nun zu Figur 11. Figur 11 zeigt einen Stecker 20, der am Ende eines Kabels 19 angeordnet ist. Dieser Stecker 20 weist an seiner Unterseite 2 einzelne Kontaktstifte 3 auf, beispielsweise Kontaktstifte der Art, wie sie in den Figuren 7, 9 und 10 dargestellt sind. Die Darstellung der Figur 11 ist nur vereinfacht zu verstehen. Wenn eine Leiterplatte in einem der Anordnung der Kontaktstifte 3 des Steckers 20 entsprechenden Muster durchkontaktierte Öffnungen aufweist, so lässt sich ein solcher Stecker 20 mit seinen Kontaktstiften 3 direkt in diese durchkontaktierten Öffnungen einpressen. Es wird also eine Steckverbindung zwischen einem Stecker und einer Leiterplatte ermöglicht, ohne dass es eine Steckbuchse oder einen Stecksockel hierfür gibt.

## Patentansprüche

1. Steckelement, insbesondere Schaltelement, für Kraftfahrzeuge, mit
1.1 einem Gehäuse (1, 10, 20), sowie mit
1.2 an einer Unterseite (2) des Gehäuses (1, 10, 20) aus diesem herausgeführten Kontaktelementen (3), die
1.3 zur direkten leitenden und mechanischen Verbindung mit einer Leiterplatte (4) ausgebildet sind.
2. Steckelement nach Anspruch 1, bei dem die Kontaktelemente als Kontaktstifte (3) zum Einlöten in Bohrungen (5) der Leiterplatte (4) ausgebildet sind.
3. Steckelement nach Anspruch 1, bei dem die Kontaktelemente als Kontaktstifte (3) zum Einpressen in durchkontaktierte Bohrungen (5) der Leiterplatte (4) ausgebildet sind.
4. Steckelement nach einem der vorhergehenden Ansprüche, bei dem die räumliche Anordnung der Kontaktstifte (3) der räumlichen Anordnung der genormten Flachsteckzungen entspricht.
5. Steckelement nach Anspruch 4, bei dem anstelle einer Flachsteckzunge zwei Kontaktstifte (3) angeordnet sind, die an der Stelle der Seitenkanten der Flachsteckzungen angeordnet sind.
6. Steckelement nach einem der vorhergehenden Ansprüche, bei dem drei Kontaktstifte (3) für eine Flachsteckzunge angeordnet sind.
7. Steckelement nach einem der vorhergehenden Ansprüche, bei dem mindestens ein Kontaktstift (3) massiv ausgebildet ist.
8. Steckelement nach einem der vorhergehenden Ansprüche, bei dem mindestens ein Kontaktstift (13) mit einem Längsschlitz (14, 24) ausgebildet ist.
9. Steckelement nach Anspruch 1, bei dem die aus dem Gehäuse herausgeführten Kontaktelemente zur Verbindung in SMT-Technologie ausgebildet sind.
10. Steckelement nach einem der vorhergehenden Ansprüche, als Relais beziehungsweise Mikrorelais ausgebildet.
11. Steckelement nach einem der Ansprüche 1 bis 9, als Sicherung ausgebildet.
12. Leiterplatte für ein Kraftfahrzeug, mit durchkontaktierten Bohrungen (5) zur Anbringung der Kontaktstifte (3, 13, 23) eines Steckelements nach einem der vorhergehenden Ansprüche.
13. Leiterplatte nach Anspruch 12, bei dem die durchkontaktierten Bohrungen (5) in einem dem normierten Anordnungsmuster der Flachsteckzungen von Steckelementen entsprechenden Bohrbild angeordnet sind.
14. Leiterplatte nach Anspruch 12 oder 13, mit in durchkontaktierten Bohrungen (5) der Leiterplatte (4) eingepressten Kontaktstiften (3, 13, 23) mindestens eines Steckelements nach einem der Ansprüche 1 bis 11.
15. Kombination aus einer Leiterplatte (4) mit durchkontaktierten Bohrungen (5) und mindestens einem Steckelement und/oder Schaltelement nach einem der Ansprüche 1 - 11.
